(19) **Europäisches Patentamt**
**European Patent Office**
**Office européen des brevets**

(11) **EP 4 640 921 A1**

(12) **EUROPEAN PATENT APPLICATION**
published in accordance with Art. 153(4) EPC

(43) Date of publication:
**29.10.2025 Bulletin 2025/44**

(21) Application number: **23907645.8**

(22) Date of filing: **18.12.2023**

(51) International Patent Classification (IPC):
**C23C 28/00** (2006.01)      **C23C 2/26** (2006.01)
**C23C 2/06** (2006.01)      **C22C 18/04** (2006.01)

(52) Cooperative Patent Classification (CPC):
**C22C 18/04; C23C 2/06; C23C 2/26; C23C 28/00**

(86) International application number:
**PCT/KR2023/020847**

(87) International publication number:
**WO 2024/136360 (27.06.2024 Gazette 2024/26)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **19.12.2022 KR 20220178333**

(71) Applicant: **POSCO Co., Ltd**
**Pohang-si, Gyeongsangbuk-do 37859 (KR)**

(72) Inventors:
• **LEE, Dong-Yoeul**
**Gwangyang-si, Jeollanam-do 57807 (KR)**
• **KIM, Yeon-Ho**
**Gwangyang-si, Jeollanam-do 57807 (KR)**
• **CHOI, Ha-Na**
**Gwangyang-si, Jeollanam-do 57807 (KR)**
• **KIM, Gyo-Sung**
**Gwangyang-si, Jeollanam-do 57807 (KR)**
• **CHO, Yong-Kyun**
**Seoul 06194 (KR)**

(74) Representative: **Meissner Bolte Partnerschaft
mbB**
**Patentanwälte Rechtsanwälte**
**Postfach 86 06 24**
**81633 München (DE)**

(54) **PLATED STEEL SHEET HAVING EXCELLENT DEGREASING PROPERTIES AND METHOD FOR MANUFACTURING SAME**

(57) The present invention relates to: a plated steel sheet having excellent degreasing properties as a high anticorrosive alloy plated steel plate containing magnesium; and a method for manufacturing same.

**Description**

Technical Field

The present disclosure relates to a plated steel sheet having excellent degreasing properties as a high-corrosion-resistant alloy plated steel sheet comprising magnesium, and a method for manufacturing the same.

Background Art

A zinc-based plated steel sheet has a property of sacrificial corrosion, in which zinc having a lower oxidation-reduction potential than iron corrodes first to suppress corrosion of a steel material, when exposed to a corrosive environment. In addition, as zinc in a plating layer oxidizes, dense corrosion products are formed on a surface of the steel material, which blocks the steel material from an oxidizing atmosphere, thereby improving corrosion resistance of the steel material. Due to these advantageous properties, the scope of applications of the zinc-based plated steel sheet has recently been expanded to steel sheets for construction materials, home appliances, and automobiles.
However, a corrosive environment is gradually worsening due to an increase in air pollution due to industrial advancement, and regulations on resource and energy savings are becoming stricter. Therefore, there is a need to develop a steel material having better corrosion resistance than conventional zinc-based plated steel sheets.
In order to solve these problems, various studies have been conducted on a technique for manufacturing a zinc alloy-based plated steel sheet having high corrosion resistance by adding elements such as aluminum (Al) and magnesium (Mg) to a zinc plating bath to further improve corrosion resistance of a steel material. A representative example is an Al-Mg-Zn-based high-corrosion-resistant alloy plated steel sheet comprising zinc (Zn), magnesium (Mg), and aluminum (Al).
However, even in the case of such high-corrosion-resistant alloy-plated steel sheets, poor degreasing after anti-rusting oil application has caused problems in subsequent treatment processes such as phosphate treatment and Zr treatment, and until now, a technique that may meet the high-end demand for an Al-Mg-Zn-based high-corrosion-resistant alloy plated steel sheet having excellent degreasing properties has not been developed.

[Related Art Document]

[Patent Documents]

(Patent Document 1) Korean Patent Publication No. 2013-0133358

Summary of Invention

Technical Problem

An aspect of the present disclosure is to provide a plated steel sheet having excellent degreasing properties and a method for manufacturing the same.
Another aspect of the present disclosure is to provide a plated steel sheet having excellent degreasing properties and high corrosion resistance, and a method for manufacturing the same.
An object of the present disclosure is not limited to the above description. Those skilled in the art to which the present disclosure pertains will have no difficulty in understanding an additional object of the present disclosure from the entire content of the present specification.

Solution to Problem

According to an aspect of the present disclosure, a plated steel sheet includes:

a base steel sheet;
a surface coating layer provided on at least one surface of the base steel sheet; and
an Al-Mg-Zn-based plating layer provided between the base steel sheet and the surface coating layer,
wherein the surface coating layer is
a metal coating layer consisting of one or more selected from the group consisting of Fe, Zn, Al, and Si, or
an aqueous coating layer comprising one or more components selected from the group consisting of P, Zn, Mn, Mo, and B.

According to another aspect of the present disclosure, a method for manufacturing a plated steel sheet includes:

immersing a base steel sheet in an Al-Mg-Zn-based plating bath to form an Al-Mg-Zn-based plating layer on a surface of the base steel sheet; and
forming a surface coating layer on a surface of the Al-Mg-Zn-based plating layer,
wherein in the forming of the surface coating layer,
a metal coating layer consisting of one or more selected from the group consisting of Fe, Zn, Al, and Si is formed by using a material consisting of one or more selected from the group consisting of Fe, Zn, Al, and Si, by using a method selected from the group consisting of a physical vapor deposition method, an electroplating method, and an electroless plating method, or
an aqueous coating layer is formed by coating a coating solution comprising an oxide, hydroxide, and water-soluble salt of one or more components selected from the group consisting of P, Zn, Mn, Mo, and B, and a solvent to the Al-Mg-Zn-based plating layer and performing heating and drying.

Advantageous Effects of Invention

According to an aspect of the present disclosure, it is possible to provide a plated steel sheet having excellent degreasing properties and a method for manufacturing the same.
According to another aspect of the present disclosure, it is possible to provide a plated steel sheet having excellent degreasing properties and high corrosion resistance, and a method for manufacturing the same.
Various and beneficial merits and effects of the present disclosure are not limited to the descriptions above, and may be more easily understood in a process of describing specific example embodiments in the present disclosure.

Best Mode for Invention

Hereinafter, preferred example embodiments of the present disclosure will be described. However, the example embodiments of the present disclosure may be modified into various other forms, and the scope of the present disclosure is not limited to the example embodiments described below. In addition, the example embodiments of the present disclosure are provided to more fully describe the present disclosure to those skilled in the art.
The meaning of "comprising" used in the specification is to specify the configuration and does not exclude the presence or addition of other configurations.
Unless otherwise defined, all the terms including the technical terms and scientific terms used in the present specification have the same meanings as commonly understood by those skilled in the art to which the present disclosure pertains. The terms defined in the preamble are interpreted as being consistent with the relevant technical literature and the disclosure herein.
Hereinafter, a plated steel sheet according to an aspect of the present disclosure will be described in detail. In the present disclosure, a content of each element means weight(wt)%, unless otherwise defined.
A conventional Al-Mg-Zn-based plated steel sheet has excellent corrosion resistance compared to a Zn-based plated steel sheet, but Al-Mg-Zn-based plating has poor degreasing properties. Specifically, in the case of the Al-Mg-Zn-based plating, poor degreasing after anti-rusting oil application causes a problem in subsequent chemical conversion treatment processes such as phosphate treatment and Zr treatment.
In the degreasing property problem, it is considered that one of the causes is magnesium (Mg), which is added to the plating layer to improve corrosion resistance, and oxides generated by the strong oxygen affinity of Mg and surfactant components in the anti-rusting oil are adsorbed, causing deterioration of the degreasing properties.
Therefore, when direct contact between magnesium oxide and anti-rusting oil may be prevented, the degreasing property problem of the high-corrosion-resistant alloy plated steel sheet may be solved; however, when applied to a steel sheet for an automobile, contact between magnesium oxide and anti-rusting oil should be prevented through a method that does not affect subsequent processes such as phosphate treatment and Zr treatment.
Therefore, as a result of conducting repeated studies to solve the problems described above, the present inventors have found that the problems described above may be solved by forming a surface coating layer capable of serving as a barrier layer that prevents an interaction between the Mg component in the plating layer and the anti-rusting oil on the surface of the Al-Mg-Zn-based plating layer, thereby completing the present disclosure. Hereinafter, the configuration of the present disclosure will be described in detail.
A plated steel sheet according to an aspect of the present disclosure includes: a base steel sheet; a surface coating layer provided on at least one surface of the base steel sheet; and an Al-Mg-Zn-based plating layer provided between the base steel sheet and the surface coating layer.
In the present disclosure, the type of the base steel sheet may not be particularly limited. For example, the base steel sheet may be an Fe-based base steel sheet used as a base steel sheet of a conventional zinc-based plated steel sheet, that is, a hot-rolled steel sheet or a cold-rolled steel sheet, but is not limited thereto. Alternatively, for example, the base steel sheet may be carbon steel, ultra-low carbon steel, or high manganese steel used for construction, home appliances, or automobiles, or may be stainless steel or the like. Meanwhile, in the case of the carbon steel, ultra-low carbon steel, medium-low carbon steel, low carbon steel, and carbon steel all exhibit similar effects, and there is no need to specifically limit the steel components; thus, it is hardly affected by components such as Mn, Si, Ti, Nb, and B, which are added in large quantities to high-strength steel and ultra-high-strength steel. Meanwhile, examples of the base steel sheet include a base steel sheet comprising, by wt%, more than 0% and 0.18% or less of C, more than 0% and 1.5% or less of Si, 0.01 to 2.70% of Mn, more than 0% and 0.07% or less of P, more than 0% and 0.015% or less of S, more than 0% and 0.5% or less of Al, 0.06% or less (including 0%) of Nb, 1.1% or less (including 0%) of Cr, 0.06% or less (including 0%) of Ti, 0.03% or less (including 0%) of B, and a balance of Fe and other unavoidable impurities. Alternatively, other examples of the base steel sheet include a base steel sheet comprising, by wt%, more than 0% and 0.18% or less of C, more than 0% and 1.5% or less of Si, 0.01 to 2.70% of Mn, more than 0% and 0.07% or less of P, more than 0% and 0.015% or less of S, more than 0% and 0.5% or less of Al, more than 0% and 0.06% or less of Nb, more than 0% and 1.1% or less of Cr, more than 0% and 0.06% or less of Ti, more than 0% and 0.03% or less of B, and a balance of Fe and other unavoidable impurities.

According to an aspect of the present disclosure, a surface coating layer described below may be provided on at least one surface of the base steel sheet. The surface coating layer may be formed on only one surface of the base steel sheet, or may be formed on both surfaces of the base steel sheet.

In addition, according to an aspect of the present disclosure, an Al-Mg-Zn-based plating layer may be provided between the base steel sheet and the surface coating layer. Although not specifically limited, in the present specification, the Al-Mg-Zn-based plating layer refers to a plating layer that comprises Mg and Al and comprises Zn as a main component (that is, in an amount of more than 50 wt%).

Although not specifically limited, according to an aspect of the present disclosure, the Al-Mg-Zn-based plating layer may contain, by wt%, 0.1 to 15.0% of Mg, 1.5 to 15.0% of Al, and a balance of Zn and unavoidable impurities.

Mg: 0.1 to 15.0%

Magnesium (Mg) is an element that serves to improve corrosion resistance of a plated steel sheet, and in order to ensure high corrosion resistance desired in the present disclosure, a content of Mg in the plating layer may be set to be 0.1% or more. However, when the content of Mg is excessive, dross may be generated. Therefore, the content of Mg may be set to be 15.0% or less.

Al: 1.5 to 15.0%

In general, when Mg is added, the effect of improving corrosion resistance is exhibited, but as the content of Mg increases, the generation of floating dross in the plating bath due to oxidation of Mg increases; thus, there is a problem that the dross should be removed frequently. In order to solve these problems, Al may be added to the plating layer in an amount of 1.5% or more. However, when Al is added excessively to suppress dross, a melting point of the plating bath increases, and an operating temperature becomes too high accordingly, which may cause problems due to high-temperature work such as erosion of the plating bath structure and transformation of the steel material. Therefore, a content of Al may be set to be 15.0% or less.

Balance of Zn and unavoidable impurities

In addition to the composition of the plating layer described above, a balance may be Zn and other unavoidable impurities. Any unavoidable impurities may be contained as long as they are unintentionally mixed in a typical manufacturing process of a hot-dip zinc-based plated steel sheet, and those skilled in the art may easily understand the meaning.

According to an example embodiment of the present disclosure, the Al-Mg-Zn-based plating layer may further contain one or more of the following groups (a) to (h).

However, since the elements of each group below are not essential elements for achieving the object of the present disclosure, a lower limit of the content of each element is not limited. Therefore, even when not specifically mentioned below, the lower limit of the content of each element may be 0%.

    (a) One or more of 0.5% or less of Si and 0.5% or less of Ni
    (b) One or more of 1.0% or less of Ca, 0.1% or less of La, 0.1% or less of Ce, 0.1% or less of Y, and 1.0% or less of Sr
    (c) 0.1% or less of Ti
    (d) 0.5% or less of W
    (e) 2.0% or less of Cu

(f) One or more of 1.0% or less of Fe, 0.5% or less of Cr, 0.5% or less of Mn, and 0.5% or less of V

(g) One or more of 0.1% or less of B and 0.1% or less of P

(h) One or more of 1.0% or less of Sn, 1.0% or less of Sb, and 1.0% or less of Bi

(a) One or more of 0.5% or less of Si and 0.5% or less of Ni

Si has the effect of preventing Fe-Zn alloying due to the formation of interface $Mg_2Si$, and may prevent excessive formation of an Fe-Al alloy phase. However, when a content of thereof exceeds 0.5%, the melting point of the plating bath may increase and brittleness may increase due to excessive formation of $Mg_2Si$. Ni has the effect of preventing Fe diffusion by forming an Al-Ni alloy phase, but when a content of Ni exceeds 0.5%, the cost of secondary raw materials may increase excessively.

(b) One or more of 1.0% or less of Ca, 0.1% or less of La, 0.1% or less of Ce, 0.1% or less of Y, and 1.0% or less of Sr

Ca, La, Ce, Y, and Sr have the effect of preventing oxidation of Mg in the plating bath by forming an oxide film, but when contents of these elements exceed 1.0%, 0.1%, 0.1%, 0.1%, and 1.0%, respectively, Ca may cause an increase in dross due to an increase in oxides, and La, Ce, Y, and Sr may cause deterioration of platability due to an increase in viscosity of the plating bath.

(c) 0.1% or less of Ti

Ti has the effect of refining grains (spangles) because a Ti-Al intermetallic compound acts as a nucleation site, but when a content of Ti exceeds 0.1%, the melting point of the plating bath may increase and dross may increase.

(d) 0.5% or less of W

W forms W oxide on the surface, which improves corrosion resistance, but when a content of W exceeds 0.5%, the melting point of the plating bath may increase.

(e) 2.0% or less of Cu

Cu has the effect of forming an Al-Cu eutectic structure and lowering the hardness of the plating layer, but when a content of Cu exceeds 2.0%, the spangles may coarsen.

(f) One or more of 1.0% or less of Fe, 0.5% or less of Cr, 0.5% or less of Mn, and 0.5% or less of V

Fe, Cr, Mn, and V have the effect of preventing electrode deterioration by suppressing alloying between zinc and a welding electrode due to rapid liquid loss, but when contents of these elements exceed 1.0%, 0.5%, 0.5%, and 0.5%, respectively, the melting point of the plating bath may increase excessively.

(g) One or more of 0.1% or less of B and 0.1% or less of P

B and P have the effect of suppressing welding LME cracks, but when a content of each element exceeds 0.1%, dross generation may increase.

(h) One or more of 1.0% or less of Sn, 1.0% or less of Sb, and 1.0% or less of Bi

Sn, Sb, and Bi have the effect of implementing uniform spangles and improving pot durability by lowering the plating bath temperature, but when a content of each element exceeds 1.0%, the spangles may coarsen.

In order to effectively serve as the barrier layer described above, the surface coating layer may be a metal coating layer or an aqueous coating layer. Hereinafter, each coating layer will be described.

First, in order for the metal coating layer described above to effectively function as a barrier layer that prevents an interaction between Mg in the plating layer and the anti-rusting oil, the metal coating layer may be consisting of one or more selected from the group consisting of Fe, Zn, Al, and Si. That is, since the metal coating layer is a barrier layer for preventing an interaction between Mg and the anti-rusting oil, it is preferable that the metal coating layer does not contain Mg, and the metal coating layer is consisting of one or more selected from the group consisting of Fe, Zn, Al, and Si, or more preferably, may be an Fe plating layer, a Zn plating layer, or an Al plating layer.

Although not particularly limited, according to an aspect of the present disclosure, an average thickness of the metal coating layer may be 10 to 3,000 nm. In order for the metal coating layer to effectively serve as a barrier layer that preferably prevents an interaction between oxides derived from Mg in the plating layer and the anti-rusting oil, the average thickness of the metal coating layer may be set to be 10 nm or more. On the other hand, when the thickness of the metal coating layer is too excessive, it may be economically disadvantageous when considering the coating time and the amount of coating material used, and corrosion resistance may also be insufficient; thus, an upper limit of the average thickness may be set to be 3,000 nm.

Meanwhile, in terms of further improving the effects described above, a lower limit of the average thickness of the metal coating layer may be 20 nm, or the upper limit of the average thickness of the metal coating layer may be 1,000 nm.

Although not particularly limited, according to an aspect of the present disclosure, the metal coating layer may satisfy the following Relational Expression 1:

$$[\text{Relational Expression 1}]$$

$$0.003 \leq Ts/Tp \leq 0.400$$

wherein Tp represents an average thickness of the Al-Mg-Zn-based plating layer, and Ts represents an average thickness of the metal coating layer.

In this case, in Relational Expression 1, since the units of Tp and Ts need only be the same as each other, the units are not particularly limited.

Although not particularly limited, according to an aspect of the present disclosure, the metal coating layer may be formed by using a material formed of one or more selected from the group consisting of Fe, Zn, Al, and Si, by using a method selected from the group consisting of a physical vapor deposition method, an electroplating method, and an electroless plating method. However, as a preferred example, the metal coating layer may be formed using a physical vapor deposition (PVD) sputtering method, through which a thin metal coating layer having an average thickness in a range of 10 to 3,000 nm may be easily formed.

According to an aspect of the present disclosure, as described above, the metal coating layer is formed on at least one surface of the Al-Mg-Zn-based plating layer, such that the interaction between Mg in the plating layer and the anti-rusting oil may be effectively prevented, and subsequent chemical conversion treatments such as phosphate treatment and Zr treatment may be performed.

Meanwhile, in order for the aqueous coating layer described above to effectively serve as a barrier layer that prevents the interaction between Mg in the plating layer and the anti-rusting oil, the aqueous coating layer may contain one or more components selected from the group consisting of P, Zn, Mn, Mo, and B. In this case, the aqueous coating layer may mean a coating layer having hydrophilic properties. That is, as described below, the aqueous coating layer may mean a coating layer that may be dissolved by a hydrophilic solvent such as an aqueous solution or an alkaline solution, and accordingly, the aqueous coating layer may be delaminated by a treatment with the hydrophilic solvent such as the aqueous solution or the alkaline solution.

Although not particularly limited, according to an aspect of the present disclosure, the aqueous coating layer may be formed by applying a coating solution comprising an oxide, hydroxide, and water-soluble salt of one or more components selected from the group consisting of P, Zn, Mn, Mo, and B, and a solvent, to the Al-Mg-Zn-based plating layer and performing heating and drying. Specifically, the aqueous coating layer may be formed by applying the coating solution to the Al-Mg-Zn-based plating layer and then performing heating and drying at 80 to 100°C for 10 seconds or less (excluding 0 seconds).

For example, the aqueous coating layer may be formed by applying the coating solution comprising a boric acid-based oxide, hydroxide, and water-soluble salt, or a phosphoric acid-based oxide, hydroxide, and water-soluble salt, and a solvent to the Al-Mg-Zn-based plating layer, and performing heating and drying.

Although not particularly limited, according to an aspect of the present disclosure, the aqueous coating layer may contain one or more components selected from the group consisting of P and B, or the aqueous coating layer may contain, by wt%, 5 to 45% of one or more selected from the group consisting of P and B.

Alternatively, although not particularly limited, according to an aspect of the present disclosure, the aqueous coating layer may contain: one or more components selected from the group consisting of P and B; and one or more components selected from the group consisting of Zn, Mn, and Mo.

Although not particularly limited, according to an aspect of the present disclosure, the aqueous coating layer may contain, by wt%, 5 to 45% of one or more components selected from the group consisting of P and B, and/or may contain, by wt%, 2.5 to 30.0% of one or more selected from the group consisting of Zn, Mn, and Mo.

Although not particularly limited, according to an aspect of the present disclosure, a coating weight per surface of the aqueous coating layer is 100.0 to 900.0 mg/m$^2$. By setting the deposition amount per surface of the aqueous coating layer to 100.0 mg/m$^2$ or more, contact between the anti-rusting oil and the plating layer may be effectively prevented, thereby ensuring good degreasing properties. However, when the deposition amount per surface of the aqueous coating layer exceeds 900.0 mg/m$^2$, problems with weldability or economic feasibility due to an increase in raw material usage may occur.

Although not particularly limited, in order to further improve the effects described above, when the aqueous coating layer comprises P, B, and Mo, the coating weight per surface may be set to be 100.0 to 900.0 mg/m$^2$. Similarly, when the aqueous coating layer comprises P, Mn, and Zn, the coating weight per surface may be set to be 100.0 to 900.0 mg/m$^2$ .

Meanwhile, the aqueous coating layer is a water-soluble film comprising one or more components selected from the group consisting of P, Zn, Mn, Mo, and B, and may be formed by the method described above using a coating solution having a pH of 2 or higher and comprising 20% or less (excluding 0%) of phosphoric acid or boric acid that reacts with the plating layer in the solution. The aqueous coating layer thus formed is a water-soluble coating layer, which should be dissolved by an aqueous solution or an alkaline solution for subsequent chemical conversion treatments, and may have a removal rate of 80% or more during dissolution.

According to an aspect of the present disclosure, as described above, the aqueous coating layer is formed on at least one surface of the Al-Mg-Zn-based plating layer, such that the interaction between Mg in the plating layer and the anti-rusting oil may be effectively prevented, and the aqueous coating layer may be delaminated during a water washing process or a degreasing process. Accordingly, after the degreasing process, the aqueous coating layer described above is delaminated and removed, such that a plated steel sheet using a delamination-type coating layer that is not affected by a subsequent chemical conversion treatment such as phosphate treatment or Zr treatment may be provided.

According to another aspect of the present disclosure, a method for manufacturing a plated steel sheet will be described.

A base steel sheet is immersed in an Al-Mg-Zn-based plating bath to form an Al-Mg-Zn-based plating layer on a surface of the base steel sheet. In this case, the composition and content of each component of the Al-Mg-Zn-based plating bath are the same as those of the Al-Mn-Zn-based plating layer. Therefore, the same descriptions of the reasons for adding each component of the plating layer and the reasons for limiting the content may be applied to the Al-Mg-Zn-based plating bath.

Next, a surface coating layer is formed on a surface of the Al-Mg-Zn-based plating layer.

When forming the surface coating layer, a metal coating layer consisting of one or more selected from the group consisting of Fe, Zn, Al, and Si may be formed by using a material formed of one or more selected from the group consisting of Fe, Zn, Al, and Si, by using a method selected from the group consisting of a physical vapor deposition method, an electroplating method, and an electroless plating method, or an aqueous coating layer may be formed by applying a coating solution comprising an oxide, hydroxide, and water-soluble salt of one or more selected from the group consisting of P, Zn, Mn, Mo, and B, and a solvent to the Al-Mg-Zn-based plating layer and then performing heating and drying. Meanwhile, since the solvent may be any water-soluble solvent commonly used in the related art, the solvent is not particularly limited, and representative examples thereof may include water.

In this case, the same description of the plated steel sheet described above may be applied to the surface coating layer.

Meanwhile, although not particularly limited, according to an aspect of the present disclosure, when forming the aqueous coating layer, the coating solution may be applied to the Al-Mg-Zn-based plating layer, and then heating and drying may be performed by a heat treatment at 80 to 100°C for 10 seconds or less (excluding 0 seconds).

Mode for Invention

(Examples)

Hereinafter, the present disclosure will be described more specifically with reference to Examples. However, it should be noted that the following Examples are only for illustrating the present disclosure in more detail and are not intended to limit the scope of the present disclosure. This is because the scope of the present disclosure is determined by the matters described in the claims and the matters able to be reasonably inferred therefrom.

(Experimental Example 1)

An Al-Mg-Zn-based plating layer comprising 1.2% of Mg, 1.7% of Al, and a balance of Zn and other unavoidable impurities was formed on a surface of a base steel sheet to an average thickness of 8 $\mu$m, and then, a metal coating layer was formed, as a surface coating layer, on a surface of the Al-Mg-Zn-based plating layer using a physical vapor deposition (PVD) sputtering method under the conditions shown in Table 1. At this time, as shown in Table 1, a specimen in which the average thickness of the surface coating layer was controlled by controlling a coating time was manufactured.

Next, in order to evaluate the degreasing properties, the specimen was immersed in 90EG anti-rusting oil manufactured by Buhmwoo, oiled, and placed upright for 72 hours, and then degreased for 90 seconds in a degreasing solution using EC-90 manufactured by Nippon Paint, to evaluate the wettability of the specimen surface. A case in which the wettability of the surface was 80% or more and less than 90% was evaluated as "∆", a case in which the wettability of the surface was 90% or more (including 100%) was evaluated as "o", and other cases were evaluated as "X". The results thereof are shown in Table 1.

In addition, in order to evaluate the phosphatability, each specimen was surface-treated and treated with phosphate according to the standard automobile manufacturer's specifications, and the uniformity of phosphate was evaluated. A case in which the phosphate was formed uniformly was evaluated as "o", and a case in which the phosphate was formed unevenly was evaluated as "X".

[Table 1]

| No. | Coating material of surface coating layer | Coating time (min) | Average thickness of surface coating layer (nm) | Wetting after degreasing | Phosphatability |
|---|---|---|---|---|---|
| Inventive Example 1 | Fe | 1 | <10 | ∆ | ○ |
| Inventive Example 2 | Fe | 5 | 32 | ○ | ○ |
| Inventive Example 3 | Fe | 30 | 129 | ○ | ○ |
| Inventive Example 4 | Fe | 60 | 256 | ○ | ○ |
| Inventive Example 5 | Zn | 1 | <14 | ∆ | ○ |
| Inventive Example 6 | Zn | 5 | 62 | ○ | ○ |
| Inventive Example 7 | Zn | 30 | 339 | ○ | ○ |
| Inventive Example 8 | Zn | 60 | 200 | ○ | ○ |
| Comparative Example 1 | X | X | X | X | X |
| Comparative Example 2 | Ni | 1 | <8 | X | ○ |
| Comparative Example 3 | Ni | 60 | 380 | X | ○ |

As can be seen from the results in Table 1, in the cases of Inventive Examples 1 to 8 in which a metal coating layer was provided as the surface coating layer according to the present disclosure, it was confirmed that the degreasing properties were better than those of Comparative Examples 1 to 3. In particular, in the cases of Inventive Examples 2 to 4 and 6 to 8 in which an average thickness of the metal coating layer satisfied 20 nm or more, it was confirmed that the degreasing properties were even better than those of Inventive Examples 1 and 5.

On the other hand, in the case of Comparative Example 1 in which no surface coating layer was formed on the surface of the Al-Mg-Zn-based plating layer, it was confirmed that the degreasing properties and phosphatability were very poor.

Meanwhile, in the cases of Comparative Examples 2 and 3 in which a Ni metal layer was provided as a metal coating layer, it was confirmed that the degreasing properties were poor because the adsorption of the Al-Mg-Zn-based plating layer and the anti-rusting oil was not prevented despite the increase in the thickness of the surface coating layer.

(Experimental Example 2)

In the same manner as in Experimental Example 1, an Al-Mg-Zn-based plating layer was formed on a surface of a base steel sheet. In order to form an aqueous coating layer as a surface coating layer on a surface of the Al-Mg-Zn-based plating layer, a phosphoric acid-based aqueous solution 1 comprising a hypophosphorous acid solution, ethanol, zinc oxide, and manganese, and a boric acid-based aqueous solution 2 comprising ammonium pentaborate, ammonium molybdate, and ethanol were prepared. As shown in Table 2, each of the phosphoric acid-based aqueous solution 1 and the boric acid-based aqueous solution 2 was applied onto the surface of the Al-Mg-Zn-based plating layer by roll coating in the coating weight shown in Table 2, and a heating and drying treatment was performed up to 80°C within 10 seconds based on the surface temperature of the plated steel sheet, thereby forming an aqueous coating layer comprising one or more selected from the group consisting of P, Zn, Mn, Mo, and B.

Next, the evaluation of degreasing properties and phosphatability was performed in the same manner as in Experimental Example 1 described above, and the results thereof are shown in Table 2.

[Table 2]

| No. | Coating solution used in forming surface coating layer | coating weight per surface of surface coating layer (mg/m$^2$) | Wetting after degreasing | Phosphatability |
|---|---|---|---|---|
| Comparative Example 4 | X | X | X | X |
| Inventive Example 9 | Boric acid-based aqueous solution 2 | 98.5 | Δ | ○ |
| Inventive Example 10 | Boric acid-based aqueous solution 2 | 165.4 | ○ | ○ |
| Inventive Example 11 | Boric acid-based aqueous solution 2 | 211.3 | ○ | ○ |
| Inventive Example 12 | Boric acid-based aqueous solution 2 | 349.1 | ○ | ○ |
| Inventive Example 13 | Boric acid-based aqueous solution 2 | 867.6 | ○ | ○ |
| Inventive Example 14 | Phosphoric acid-based aqueous solution 1 | 148.0 | Δ | ○ |
| Inventive Example 15 | Phosphoric acid-based aqueous solution 1 | 236.0 | Δ | ○ |
| Inventive Example 16 | Phosphoric acid-based aqueous solution 1 | 300.0 | ○ | ○ |
| Inventive Example 17 | Phosphoric acid-based aqueous solution 1 | 542.0 | ○ | ○ |
| Inventive Example 18 | Phosphoric acid-based aqueous solution 1 | 882.0 | ○ | ○ |

As can be seen from the results in Table 2, in the cases of Inventive Examples 9 to 18 in which an aqueous coating layer was provided as the surface coating layer according to the present disclosure, it was confirmed that at least one of the degreasing properties and phosphatability was superior to that of Comparative Example 4. In addition, in the cases of Inventive Examples 9 to 18, it was confirmed that the aqueous coating layer was completely removed (delaminated) when treated with an aqueous solution or an alkaline solution, and the removal rate was 80% or more (including 100%). In addition, in the cases of the plated steel sheets obtained from Inventive Examples 9 to 18, it was confirmed that the aqueous coating layer contained, by wt%, 5 to 45% of one or more components selected from the group consisting of P and B, and contained, by wt%, 2.5 to 30.0% of one or more components selected from the group consisting of Zn, Mn, and Mo.

In particular, in Inventive Examples 9 to 13 in which B, Mo, and an amine compound were contained in the aqueous coating layer, it was confirmed that Inventive Examples 10 to 13 satisfying the coating weight per surface of 100.0 to 900.0 mg/m$^2$ were better in the effect of improving degreasing properties by preventing contact between the anti-rusting oil and the plating layer surface than Inventive Example 9.

In addition, among Inventive Examples 14 to 18 in which P, Mn, and Zn were contained in the aqueous coating layer, it was confirmed that Inventive Examples 16 to 18 satisfying the coating weight per surface of 100.0 to 900.0 mg/m$^2$ were better in the effect of improving degreasing properties by preventing contact between the anti-rusting oil and the plating layer surface than Inventive Examples 14 and 15.

On the other hand, in the case of Comparative Example 4 in which no surface coating layer was formed on the surface of the Al-Mg-Zn-based plating layer, it was confirmed that the degreasing properties and phosphatability were very poor.

**Claims**

1. A plated steel sheet comprising:

    a base steel sheet;
    a surface coating layer provided on at least one surface of the base steel sheet; and
    an Al-Mg-Zn-based plating layer provided between the base steel sheet and the surface coating layer,
    wherein the surface coating layer is
    a metal coating layer consisting of one or more selected from the group consisting of Fe, Zn, Al, and Si, or
    an aqueous coating layer comprising one or more components selected from the group consisting of P, Zn, Mn, Mo, and **B.**

2. The plated steel sheet of claim 1, wherein the Al-Mg-Zn-based plating layer comprises, by weight%, 0.1 to 15.0% of Mg, 1.5 to 15.0% of Al, and a balance of Zn and unavoidable impurities.

3. The plated steel sheet of claim 2, wherein the plating layer further comprises one or more of the following groups (a) to (h):

    (a) one or more of **0.5%** or less of Si and **0.5%** or less **of Ni,**
    (b) one or more of 1.0% or less of **Ca, 0.1%** or less of **La, 0.1%** or less of **Ce, 0.1%** or less of **Y,** and **1.0%** or less **of Sr,**
    (c) 0.1% or less of Ti,
    (d) 0.5% or less of **W,**
    (e) 2.0% or less of **Cu,**
    (f) one or more of 1.0% or less of **Fe, 0.5%** or less of Cr, 0.5% or less of Mn, and 0.5% or less of V,
    (g) one or more of 0.1% or less of B and 0.1% or less of P, and
    (h) one or more of 1.0% or less of Sn, 1.0% or less of Sb, and 1.0% or less of Bi.

4. The plated steel sheet of claim 1, wherein an average thickness of the metal coating layer is 10 to 3,000 nm.

5. The plated steel sheet of claim 1, wherein the metal coating layer satisfies the following Relational Expression 1:

$$[\text{Relational Expression 1}]$$

$$0.003 \le Ts/Tp \le 0.4$$

    wherein Tp represents an average thickness of the Al-Mg-Zn-based plating layer, and Ts represents an average thickness of the metal coating layer.

6. The plated steel sheet of claim **1,** wherein a coating weight per surface of the aqueous coating layer is 100.0 to 900.0 mg/m$^2$.

7. The plated steel sheet of claim **1,** wherein the aqueous coating layer comprises one or more components selected from the group consisting of P and B.

8. The plated steel sheet of claim 1, wherein the aqueous coating layer comprises, by weight%, 5 to 45% of one or more components selected from the group consisting of P and B.

9. The plated steel sheet of claim 1, wherein the aqueous coating layer comprises:

    one or more components selected from the group consisting of P and B; and
    one or more components selected from the group consisting of Zn, Mn, and Mo.

10. The plated steel sheet of claim 1, wherein the aqueous coating layer comprises, by weight%, 2.5 to 30.0% of one or more components selected from the group consisting of Zn, Mn, and Mo.

11. The plated steel sheet of claim 1, wherein the metal coating layer is formed by using a material consisting of one or more selected from the group consisting of Fe, Zn, Al, and Si, by using a method selected from the group consisting of a physical vapor deposition method, an electroplating method, and an electroless plating method.

12. The plated steel sheet of claim 1, wherein the aqueous coating layer is formed by coating a coating solution comprising an oxide, hydroxide, and water-soluble salt of one or more components selected from the group consisting of P, Zn, Mn, Mo, and B, and a solvent to the Al-Mg-Zn-based plating layer and performing heating and drying.

13. The plated steel sheet of claim 1, wherein the aqueous coating layer comprises P, B, and Mo, and has a coating weight per surface of 100.0 to 900.0 mg/m$^2$.

14. The plated steel sheet of claim 1, wherein the aqueous coating layer comprises P, Mn, and Zn, and has a coating weight per surface of 100.0 to 900.0 mg/m$^2$.

15. The plated steel sheet of claim 1, wherein the aqueous coating layer has a removal rate of 80% or more (including 100%) when treated with an aqueous solution or an alkaline solution.

16. A method for manufacturing a plated steel sheet, the method comprising:

immersing a base steel sheet in an Al-Mg-Zn-based plating bath to form an Al-Mg-Zn-based plating layer on a surface of the base steel sheet; and
forming a surface coating layer on a surface of the Al-Mg-Zn-based plating layer,
wherein in the forming of the surface coating layer,
a metal coating layer consisting of one or more selected from the group consisting of Fe, Zn, Al, and Si is formed by using a material consisting of one or more selected from the group consisting of Fe, Zn, Al, and Si, by using a method selected from the group consisting of a physical vapor deposition method, an electroplating method, and an electroless plating method, or
an aqueous coating layer is formed by coating a coating solution comprising an oxide, hydroxide, and water-soluble salt of one or more components selected from the group consisting of P, Zn, Mn, Mo, and B, and a solvent to the Al-Mg-Zn-based plating layer and performing heating and drying.

17. The method of claim 16, wherein the heating and drying is a heat treatment performed at 80 to 100°C for 10 seconds or less (excluding 0 seconds).

## INTERNATIONAL SEARCH REPORT

| International application No. |
| --- |
| **PCT/KR2023/020847** |

| A. | CLASSIFICATION OF SUBJECT MATTER |
| --- | --- |

**C23C 28/00**(2006.01)i; **C23C 2/26**(2006.01)i; **C23C 2/06**(2006.01)i; **C22C 18/04**(2006.01)i

According to International Patent Classification (IPC) or to both national classification and IPC

| B. | FIELDS SEARCHED |
| --- | --- |

Minimum documentation searched (classification system followed by classification symbols)

C23C 28/00(2006.01); B05D 7/14(2006.01); B32B 15/08(2006.01); C09D 175/04(2006.01); C09D 7/40(2018.01); C22C 38/00(2006.01); C23C 2/06(2006.01); C23C 2/30(2006.01); C23C 22/40(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 세정(cleaning), 마그네슘(Mg), 알루미늄 도금(aluminum plating), 베리어 (barrier), 코팅(coating)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | KR 10-2015-0074900 A (POSCO) 02 July 2015 (2015-07-02)<br>See paragraphs [0011]-[0012], [0026], [0028], [0075]-[0085] and [0092]-[0093], table 2 and figure 1. | 1-3,6-10,12-17 |
| Y | | 4-5,11 |
| Y | KR 10-2006-0090309 A (SUMITOMO METAL INDUSTRIES, LTD.) 10 August 2006 (2006-08-10)<br>See paragraphs [0057], [0062]-[0068] and [0131]. | 4-5,11 |
| A | KR 10-2020-0084491 A (POSCO COATED&COLOR STEEL CO., LTD.) 13 July 2020 (2020-07-13)<br>See claims 1-3, tables 1-3 and figures 1-2. | 1-17 |
| A | JP 2014-088617 A (FONTAINE HOLDINGS NV) 15 May 2014 (2014-05-15)<br>See claims 1 and 3. | 1-17 |
| A | KR 10-2015-0075183 A (POSCO) 03 July 2015 (2015-07-03)<br>See paragraph [0047], claims 4-8 and figure 1. | 1-17 |

☐ Further documents are listed in the continuation of Box C.  ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **14 March 2024** | **14 March 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**EP 4 640 921 A1**

**INTERNATIONAL SEARCH REPORT**
Information on patent family members

International application No.

**PCT/KR2023/020847**

| Patent document cited in search report | | | Publication date (day/month/year) | Patent family member(s) | | | Publication date (day/month/year) |
|---|---|---|---|---|---|---|---|
| KR | 10-2015-0074900 | A | 02 July 2015 | KR | 10-1585726 | B1 | 22 January 2016 |
| KR | 10-2006-0090309 | A | 10 August 2006 | AT | E468416 | T1 | 15 June 2010 |
| | | | | CN | 100434564 | C | 19 November 2008 |
| | | | | CN | 101144162 | A | 19 March 2008 |
| | | | | CN | 101144162 | B | 16 February 2011 |
| | | | | CN | 1575348 | A | 02 February 2005 |
| | | | | EP | 1439240 | A1 | 21 July 2004 |
| | | | | EP | 1439240 | A4 | 07 September 2005 |
| | | | | EP | 1439240 | B1 | 19 May 2010 |
| | | | | EP | 1439240 | B2 | 03 October 2018 |
| | | | | JP | 2003-129209 | A | 08 May 2003 |
| | | | | JP | 2003-129258 | A | 08 May 2003 |
| | | | | JP | 2003-147499 | A | 21 May 2003 |
| | | | | JP | 3582511 | B2 | 27 October 2004 |
| | | | | JP | 3582512 | B2 | 27 October 2004 |
| | | | | JP | 3591501 | B2 | 24 November 2004 |
| | | | | KR | 10-0646619 | B1 | 23 November 2006 |
| | | | | KR | 10-0678406 | B1 | 02 February 2007 |
| | | | | KR | 10-2004-0048981 | A | 10 June 2004 |
| | | | | US | 2004-0166360 | A1 | 26 August 2004 |
| | | | | US | 2005-0252262 | A1 | 17 November 2005 |
| | | | | US | 7673485 | B2 | 09 March 2010 |
| | | | | WO | 03-035922 | A1 | 01 May 2003 |
| KR | 10-2020-0084491 | A | 13 July 2020 | KR | 10-2170061 | B1 | 27 October 2020 |
| JP | 2014-088617 | A | 15 May 2014 | BR | 102013027372 | A2 | 21 October 2014 |
| | | | | BR | 102013027372 | B1 | 15 June 2021 |
| | | | | BR | 102013027373 | A2 | 21 October 2014 |
| | | | | BR | 102013027373 | B1 | 15 June 2021 |
| | | | | CA | 2831052 | A1 | 25 April 2014 |
| | | | | CA | 2831052 | C | 31 May 2016 |
| | | | | CA | 2831053 | A1 | 25 April 2014 |
| | | | | CA | 2831053 | C | 31 May 2016 |
| | | | | CN | 103774073 | A | 07 May 2014 |
| | | | | CN | 103774077 | A | 07 May 2014 |
| | | | | DK | 2725117 | T3 | 06 March 2017 |
| | | | | EP | 2725116 | A1 | 30 April 2014 |
| | | | | EP | 2725116 | B1 | 14 March 2018 |
| | | | | EP | 2725117 | A1 | 30 April 2014 |
| | | | | EP | 2725117 | B1 | 11 January 2017 |
| | | | | ES | 2620488 | T3 | 28 June 2017 |
| | | | | ES | 2672725 | T3 | 15 June 2018 |
| | | | | GB | 2507309 | A | 30 April 2014 |
| | | | | HU | E032909 | T2 | 28 November 2017 |
| | | | | JP | 2014-088616 | A | 15 May 2014 |
| | | | | JP | 6133753 | B2 | 24 May 2017 |
| | | | | JP | 6133754 | B2 | 24 May 2017 |
| | | | | KR | 10-2014-0052903 | A | 07 May 2014 |
| | | | | KR | 10-2014-0052904 | A | 07 May 2014 |
| | | | | KR | 10-2014155 | B1 | 21 October 2019 |
| | | | | KR | 10-2039893 | B1 | 04 November 2019 |

Form PCT/ISA/210 (patent family annex) (July 2022)

13

**INTERNATIONAL SEARCH REPORT**
Information on patent family members

International application No.

**PCT/KR2023/020847**

| Patent document cited in search report | | Publication date (day/month/year) | Patent family member(s) | | | Publication date (day/month/year) |
|---|---|---|---|---|---|---|
| | | | PL | 2725116 | T3 | 30 November 2018 |
| | | | PL | 2725117 | T3 | 31 July 2017 |
| | | | PT | 2725117 | T | 20 February 2017 |
| | | | RS | 55787 | B1 | 31 August 2017 |
| | | | US | 10745792 | B2 | 18 August 2020 |
| | | | US | 10801096 | B2 | 13 October 2020 |
| | | | US | 2014-0120369 | A1 | 01 May 2014 |
| | | | US | 2014-0120370 | A1 | 01 May 2014 |
| KR | 10-2015-0075183 A | 03 July 2015 | KR | 10-1543893 | B1 | 12 August 2015 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 20130133358